Europäisches Patentamt

European Patent Office

Office européen des brevets

(11) Veröffentlichungsnummer: **0 438 637 A1**

## (12) EUROPÄISCHE PATENTANMELDUNG

(21) Anmeldenummer: **90118646.0**

(22) Anmeldetag: **28.09.90**

(51) Int. Cl.5: **G01R 19/02**, G01R 21/08

(30) Priorität: **24.01.90 CH 215/90**

(43) Veröffentlichungstag der Anmeldung:
**31.07.91 Patentblatt 91/31**

(84) Benannte Vertragsstaaten:
**CH DE ES FR GB LI SE**

(71) Anmelder: **Landis & Gyr Betriebs AG**

**CH-6301 Zug(CH)**

(72) Erfinder: **Hesling, Gérald**
**La Petite Marche**
**F-03420 Marcillat(FR)**
Erfinder: **de Vries, Jacob**
**Feldbergstrase 2**
**CH-6319 Allenwinden(CH)**

(54) **Verfahren und Anordnung zur Ermittlung eines Effektivwertes Ieff eines mit Hilfe eines Hallelementes und einer Verstärkeranordnung zu messenden Stromes.**

(57) Das Verfahren dient dazu, "Offset"-Gleichspannungsanteile einer Anordnung zur Durchführung des Verfahrens von den durch Gleichstromanteile des zu messenden Stromes erzeugten Gleichspannungsanteile zu unterscheiden, wobei bei der Ermittlung von Ieff nur die ersteren zu korrigieren sind. In Verfahrensschritten werden zeitlich aufeinander Spannungen ermittelt, die einer "Offset"-Gleichspannung der Verstärkeranordnung (4;6;7;8), einer "Offset"-Gleichspannung des Hallelementes (5), N Abtastwerten des zu messenden Stromes, einem Summenwert der N Abtastwerte, einem Summenwert von Quadratwerten der N Abtastwerte, einer totalen "Offset"-Gleichspannung der Anordnung sowie einem Mittelwert des zu messenden Stromes entsprechen. Dann wird der Mittelwert des zu messenden Stromes mit einem Referenzwert verglichen und Ieff, falls der Mittelwert grösser ist als der Referenzwert, mit Hilfe einer ersten Formel oder, falls der Mittelwert kleiner ist als der Referenzwert, mit Hilfe einer zweiten Formel berechnet. Die Anordnung enthält Schalter (4, 11, 12), eine Konstantstromquelle (6), Verstärker (7, 8, 9, 10), einen Analog/Digital-Wandler (13) und einen Computer (14).

**Fig.1**

# VERFAHREN UND ANORDNUNG ZUR ERMITTLUNG EINES EFFEKTIVWERTES IEFF EINES MIT HILFE EINES HALLELEMENTES UND EINER VERSTÄRKERANORDNUNG ZU MESSENDEN STROMES

Die Erfindung bezieht sich auf ein Verfahren zur Ermittlung eines Effektivwertes Ieff eines mit Hilfe eines Hallelementes und einer Verstärkeranordnung zu messenden Stromes gemäss dem Oberbegriff des Anspruchs 1 sowie auf eine Anordnung zur Durchführung des Verfahrens.

Solche Verfahren eignen sich vorzugsweise zur Ermittlung von Stromwerten in Kombinations-Elektrizitätszählern, in denen neben Werte einer verbrauchten Energie auch noch andere, beim Stromverbrauch interessierende Parameterwerte, wie z. B. der Effektivwert eines Laststromes, zu ermitteln sind. Ein Beispiel eines solchen Kombinations-Elektrizitätszählers ist der sogenannte "Tarif bleu"-Elektrizitätszähler in Frankreich.

Anordnungen zur Durchführung des eingangs genannten Verfahrens sind an sich bekannt. Eine vorteilhafte Ausführung einer solchen Anordnung ist z. B. in der Fig. 1 der US-PS 4 710 652 dargestellt.

Die Verstärkeranordnung enthält mindestens einen Verstärker und weist in der Regel eine "Offset"-Gleichspannung Voff,v auf.

Das Hallelement ist in der Regel nicht ideal symmetrisch, sondern asymmetrisch aufgebaut, was eine "Offset"-Gleichspannung Voff,h des Hallelementes verursacht.

Die bei der Energieversorgung zu messenden Ströme besitzen ihrerseits oft Gleichstromanteile. Der durch sie im Messresultat verursachte Gleichspannungsanteil kann in der Regel nicht unterschieden werden von demjenigen Gleichspannungsanteil, der durch die "Offset"-Gleichspannungen Voff,h und Voff,v des Hallelementes und der Verstärkeranordnung erzeugt wird. Es ist somit in der Regel unklar, ob diese Gleichspannungsanteile echte Gleichstromanteile darstellen, die bei der Ermittlung der Effektivwerte des zu messenden Stromes nicht zu korrigieren sind, oder ob sie "Offset"-Spannungsanteile darstellen, die bei der Ermittlung der Effektivwerte zu korrigieren sind.

Der Erfindung liegt die Aufgabe zugrunde, ein Verfahren der eingangs genannten Art zu verwirklichen, in das die "Offset"-Gleichspannungsanteile von den durch die Gleichstromanteile des zu messenden Stromes erzeugten Gleichspannungsanteile unterschieden werden können, wobei bei der Ermittlung der Effektivwerte des zu messenden Stromes die ersten zu korrigieren und die letzten nicht zu korrigieren sind.

Die genannte Aufgabe wird erfindungsgemäss durch die im Kennzeichen des Anspruchs 1 angegebenen Merkmale gelöst.

Vorteilhafte Ausgestaltungen des erfindungsgemässen Verfahrens sowie vorteilhafte Anordnungen zur Durchführung des Verfahrens ergeben sich aus den Unteransprüchen.

Ein Ausführungsbeispiel einer zur Durchführung des erfindungsgemässen Verfahrens dienenden Anordnung ist in den Figuren der Zeichnung dargestellt und wird im folgenden näher beschrieben.

Es zeigen:

Fig. 1 ein Blockschaltbild einer Anordnung zur Durchführung des erfindungsgemässen Verfahrens,

Fig. 2 eine graphische Darstellung einer Spannung Vm, die proportional einem zu messenden Strom ist und deren um die Summe aller Offset"-Spannungen korrigierter Mittelwert F.Im,m grösser ist als ein Referenzwert F.It, und

Fig. 3 eine graphische Darstellung einer Spannung Vm, die proportional einem zu messenden Strom ist und deren um die Summe aller "Offset"-Spannungen korrigierter Mittelwert F.Im,m kleiner ist als ein Referenzwert F.It.

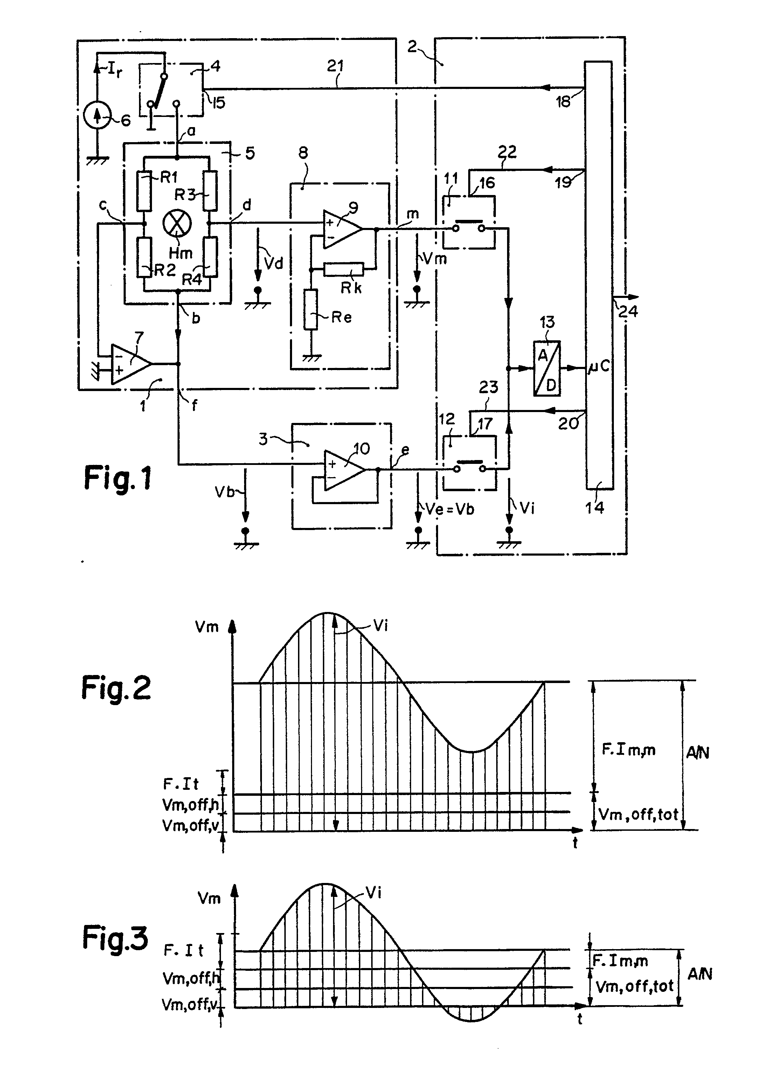

Die in der Figur 1 dargestellte Anordnung besteht aus einer Messeinrichtung 1, einer Auswerteeinrichtung 2 und einem Spannungsfolger 3. Die Messeinrichtung 1 ist annähernd gleich aufgebaut wie die in der Fig. 1 der US-PS 4 435 653 dargestellte Anordnung mit dem Unterschied, dass zusätzlich noch ein erster Schalter 4 vorhanden ist, der ein Umschalter ist. Die Messeinrichtung 1 besteht somit aus einem Hallelement 5 und einer Verstärkeranordnung 4;6;7;8, wobei die letzte aus einer Konstantstromquelle 6, dem ersten Schalter 4, einem Regelverstärker 7 und einem Messverstärker 8 besteht. Der Regelverstärker 7 ist vorzugsweise ein nichtrückgekoppelter Operationsverstärker und der Messverstärker 8 ein an sich bekannter, mittels eines weiteren Operationsverstärkers 9 aufgebauter nichtinvertierender Verstärker. Dabei bildet ein nichtinvertierender Eingang des weiteren Operationsverstärkers 9 einen nichtinvertierenden Eingang des Messverstärkers 8, während der Ausgang des weiteren Operationsverstärkers 9, der gleichzeitig ein Ausgang des Messverstärkers 8 und ein Ausgang m der Verstärkeranordnung 4;6;7;8 ist, über einen Rückkopplungswiderstand Rk mit einem invertierenden Eingang des weiteren Operationsverstärkers 9 verbunden ist. Dieser invertierende Eingang liegt ausserdem über einen Eingangswiderstand Re an Masse. Der Messverstärker 8 besitzt einen Verstärkungsfaktor K. Das Verhältnis der Werte der beiden Widerstände Rk und Re ist z. B. so gewählt, dass der Messverstärker 8 annähernd einen Verstärkungsfaktor K = 100 aufweist.

Ein Pol der Konstantstromquelle 6 liegt an Masse, während ihr zweiter, nicht an Masse liegender Pol einerseits über einen Oeffnungskontakt des den Schalter 4 bildenden Umschalters an Masse liegt und anderseits über einen Schliesskontakt dieses Umschalters mit einem ersten Pol a eines Stromeingangs a;b des Hallelementes 5 verbunden ist. Das Hallelement 5 besitzt einen zweipoligen Ausgang d;c, dessen erster Pol c auf einen invertierenden Eingang des Regelverstärkers 7 geführt ist, dessen nichtinvertierender Eingang an Masse liegt und dessen Ausgang mit einem zweiten Pol b des Stromeingangs a;b des Hallelementes 5 sowie über einen Hilfsausgang f der Verstärkeranordnung 4;6;7;8 mit einem Eingang des Spannungsfolgers 3 verbunden ist. Ein zweiter Pol d des Ausgangs d;c des Hallelementes 5 ist auf den Eingang des Messverstärkers 8 geführt, dessen Ausgang einen Ausgang der Messeinrichtung 1 bildet, der mit einem ersten Eingang der Auswerteeinrichtung 2 verbunden ist.

Der Spannungsfolger 3 besteht aus einem zusätzlichen, dritten Operationsverstärker 10, dessen nichtinvertierender Eingang den Eingang des Spannungsfolgers 3 bildet und dessen Ausgang, der gleichzeitig ein Ausgang e des Spannungsfolgers 3 ist, unmittelbar mit einem invertierenden Eingang des zusätzlichen Operationsverstärkers 10 verbunden ist. Der Ausgang des Spannungsfolgers 3 ist auf einen zweiten Eingang der Auswerteeinrichtung 2 geführt.

Die Auswerteeinrichtung 2 besteht aus einem zweiten Schalter 11, einem dritten Schalter 12, einem Analog/Digital-Wandler 13 und einem Computer 14, der vorzugsweise ein Mikrocomputer ist. Innerhalb der Auswerteeinrichtung 2 ist deren erster Eingang über den zweiten Schalter 11 und deren zweiter Eingang über den dritten Schalter 12 mit einem Eingang des Analog/Digital-Wandlers 13 verbunden, dessen Ausgang seinerseits auf einen Eingang des Computers 14 geführt ist. Somit ist auch der Ausgang m der Verstärkeranordnung 4;6;7;8 über den zweiten Schalter 11 und der zweite Pol b des Stromeingangs a;b des Hallelementes 5 über den dritten Schalter 12 mit dem Eingang des Analog/Digital-Wandlers 13 verbunden.

Die Schalter 4, 11 und 12 sind einpolige Schalter, deren Steuereingänge 15, 16 und 17 jeweils von einem von drei Ausgängen 18, 19 oder 20 des Computers 14 über je eine Verbindung 21, 22 oder 23 angesteuert und um- bzw. ein/aus-geschaltet werden. Ein vierter Ausgang 24 des Computers 14 ist mit weiteren, nicht dargestellten Bauteile der Anordnung verbunden, z. B. mit Leuchtanzeigen zur Darstellung von Messresultaten. In der Fig. 1 sind die Schalter 4, 11 und 12 als elektromechanische Kontakte dargestellt. In der Praxis werden jedoch in der Regel Halbleiterschalter verwendet.

Das Hallelement 5 ist in der Fig. 1 durch sein Ersatzschaltbild dargestellt, welches eine, aus vier Widerständen R1, R2, R3 und R4 bestehende Brückenschaltung ist. Die vier Widerstände R1 bis R4 sind theoretisch gleich gross einem Widerstand R. In der Praxis sind die vier Widerstände R1 bis R4 jedoch nur annähernd gleich gross, was eine Asymmetrie der Brückenschaltung und dadurch eine "Offset"-Gleichspannung Voff,h des Hallelementes 5 verursacht. Zur Berechnung der "Offset"-Gleichspannung Voff,h des Hallelementes 5 gilt nachfolgend die Annahme, dass die vier Widerstände R1 bis R4 folgende Werte besitzen:

$$R1 = R2 = R,$$
$$R3 = R-2\delta R \text{ und}$$
$$R4 = R+2\delta R.$$

Der Wert des Widerstandes Rh des Stromeingangs a;b des Hallelementes 5, ist dann

$$Rh = [R+R][R-2\delta R+R+2\delta R]/[R+R+R-2\delta+R+2\delta] = R$$

und der Wert des Spannungsabfalls Vh über das Hallelement 5

$$Vh = Ir.Rh = Ir.R,$$

wobei Ir ein konstanter Referenzstrom ist, der von der Konstantstromquelle 6 geliefert das Hallelement 5 über den ersten Schalter 4 speist.

Die Spannung Vc am ersten Pol c des Ausgangs d;c des Hallelementes 5 wird mit Hilfe des Regelverstärkers 7 auf Null geregelt, indem durch den Regelverstärker 7 die Spannung Vb am zweiten Pol b des Stromeingangs a;b des Hallelementes 5 solange verstellt wird, bis dass der Istwert, d. h. die Spannung Vc, gleich dem Sollwert ist, der seinerseits als Nullwert am nichtinvertierenden Eingang des Regelverstärkers 7 ansteht. Im eingeschwungenen Zustand gilt somit:

$$Vc = 0 \text{ Volt.}$$

Die Hallspannung Vd,c des Hallelementes 5, die an dessem Ausgang d;c erscheint, wenn das Hallelement 5 einem Magnetfeld Hm ausgesetzt ist, ist somit gleich der auf Massepotential bezogenen Spannung Vd, die am zweiten Pol d des Ausganges d;c des Hallelementes 5 ansteht. Sie erscheint ausserdem, durch den Messverstärker 8 um einen Verstärkungsfaktor K = 100 verstärkt, als Spannung Vm am Ausgang des Messverstärkers 8 und am ersten Eingang der Auswerteeinrichtung 2, wobei die Spannung Vm ebenfalls auf das Massepotential bezogen ist.

Da $Vc = 0$, $R1 = R2$ und der invertierende Eingang des Regelverstärkers 7 hochohmig ist, gelten ausserdem:

$$Vb = -Va = -Vh/2 = -[Ir.R]/2.$$

Ein zu messender und in der Fig. 1 nicht dargestellter Strom $i_m$ erzeugt das proportionale Magnetfeld Hm, von dem in der Darstellung der Fig. 1 angenommen wurde, dass es senkrecht zur Papierebene wirksam ist. Das Hallelement 5 ist dem Magnetfeld Hm ausgesetzt, so dass es indirekt den zu messenden Strom $i_m$ über das Magnetfeld Hm misst. Das Hallelement 5 kann ein sogenanntes vertikales oder ein sogenanntes horizontales Hallelement sein. Bei vertikalen Hallelementen muss das Magnetfeld Hm parallel und bei horizontalen Hallelementen senkrecht zur wirksamen Oberfläche des Hallelementes 5 ausgerichtet sein.

Bei Abwesenheit aller "Offset"-Gleichspannungen Voff,h und Voff,v sind die Hallspannung Vd,c des Hallelementes 5, die Spannung Vd und die Spannung Vm einerseits proportional dem zu messenden Strom $i_m$ und anderseits proportional dem konstanten Refenzstrom Ir, der das Hallelement 5 speist, so dass folgende Gleichung gilt:

$$Vm = E.Ir.i_m = F.i_m \quad (I),$$

wobei $F = E.Ir$ und E zwei Proportionalitätskonstanten sind.

Bei Anwesenheit aller "Offset"-Gleichsspannungen Voff,h und Voff,v gilt anstatt der Gleichung (I) die nachfolgende Gleichung (II):

$$Vm = F.i_m + Vm,off,tot \quad (II),$$
$$\text{mit } Vm,off,tot = Vm,off,h + Vm,off,v \quad (III).$$

Dabei besitzen die Bezeichnungen folgende Bedeutung:

- Vm,off,tot: Totale "Offset"-Gleichspannung der Messeinrichtung 1, gemessen am Ausgang des Messverstärkers 8.
- Vm,off,h : Der Teil der Ausgangsspannung Vm des Messverstärkers 8, der der "Offset"-Gleichspannung Voff,h des Hallelementes 5 entspricht.
- Vm,off,v : Der Teil der Ausgangsspannung Vm des Messverstärkers 8, der der "Offset"-Gleichspannung Voff,v der Verstärkeranordnung 4;6;7;8 entspricht.

Da der Eingangswiderstand des Messverstärkers 8 hochohmig ist, gelten folgende Gleichungen:

$$Voff,h$$
$$= [Vb] + \{[-2Vb].[R + 2\delta R]/[R + 2\delta R + R-2\delta]\}$$
$$= [-2Vb].[\delta R/R]$$
$$= L.Vb \text{ und}$$
$$Vm,off,h = K.Voff,h = K.L.Vb = G.Vb \quad (IV),$$

mit $L = -2[\delta R/R]$ und $G = K.L$ als Proportionalitätskonstanten. Die Spannung Vb entspricht somit der "Offset"-Gleichspannung Voff,h des Hallelementes 5 und die Proportionalitätskonstante G ist ein Umrechnungsfaktor, mit dem die durch den Referenzstrom Ir am zweiten Pol b des Stromeingangs a;b des Hallelementes 5 erzeugte Spannung Vb in eine zugehörige äquivalente und am Ausgang m der Verstärkeranordnung 4;6;7;8 anstehende Spannung Vm,off,h umgerechnet wird.

Die Langzeitstabilität der "Offset"-Gleichspannung Voff,h ist sehr gut, so dass ihr Wert in einer neuen Messeinrichtung an sich zu Beginn ein für allemal durch Kalibrierung ermittelt und/oder kompensiert werden kann. Dies genügt jedoch leider nicht, da die "Offset"-Gleichspannung Voff,h temperaturabhängig ist. So muss bei jeder Messreihe der Wert von Voff,h bzw. von Vm,off,h immer wieder neu ermittelt und berücksichtigt werden. Dies geschieht mit Hilfe des Spannungsfolgers 3 und des dritten Schalters 12 durch Messung der Spannung Vb am zweiten Pol b des Stromeingangs a;b des Hallelementes 5 unter Zuhilfenahme der Gleichung IV

$$Vm,off,h = G.Vb = G.Ve \quad (V),$$

wobei Ve die Ausgangsspannung des Spannungsfolgers 3 darstellt, der bekanntlich einen Verstärkungsfaktor Eins aufweist.

Da der Absolutwert von Vb, im Gegensatz zum Wert von Vd, der in der Grössenordnung von 10mV liegt, in der Grössenordnung von 2 Volt liegt, genügt bei der Messung von Vb ein Spannungsfolger 3 als Verstärker. Ausserdem kann bei der Messung von Vb als Fehler zweiter Ordnung der Fehler vernachlässigt werden, der durch den Teil der "Offset"-Gleichspannung Voff,v der Verstärker-anordnung 4;6;7;8 verursacht wird, der bei der Messung von Vb wirksam ist.

Der Spannungsfolger 3 besitzt einen hochohmigen Eingang, so dass das Hallelement 5 und der Regelverstärker 7 durch den Spannungsfolger 3 kaum belastet werden.

Mit Hilfe der Schalter 11 und 12 werden die am Ausgang des Messverstärkers 8 bzw. des Spannungsfolgers 3 anstehenden Analogsignale kurzzeitig abgetastet zur Erzeugung analoger Abtastsignale, welche anschliessend durch den Analog/Digital-Wandler 13 in Digitalwerte umgewandelt werden, die ihrerseits im Computer 14 gespeichert und zur Berechnung des Effektivwertes des gemessenen Stromes $i_m$ verwendet werden.

In Kalibrierungs-Verfahrensschritten wird zuerst einmal der für alle Messungen geltende Wert der proportionalitätskonstante G ermittelt und im Computer 14 gespeichert. Der so ermittelte Wert der Proportionalitätskonstante G gilt für alle nachfolgenden Messungen.

Der Effektivwert Ieff des zu messenden Stromes $i_m$ wird mit Hilfe folgender, zeitlich aufeinander folgender Verfahrensschritte ermittelt:

1. In einem ersten Messungsschritt wird mit einem Wert Null des Referenzstromes Ir, d. h. mit einem offenen Schliesskontakt des ersten Schalters 4, ein Wert der am Ausgang m der Verstärkeranordnung 4;6;7;8 anstehenden Spannung Vm,off,v ermittelt.

Zu diesem Zweck veranlasst der Computer 14 über die zugehörigen Steuereingänge 15 bis 17, dass zu Beginn des ersten Messungsschritts die Schliesskontakte der beiden Schalter 4 und 12 geöffnet sind und derjenige des zweiten Schalters 11 geschlossen ist. Da der Referenzstrom Ir Null ist, besitzt das Hallelement 5 als passives Bauelement in diesem ersten Messungsschritt keine "Offset"-Gleichspannung Voff,h und die in der Messeinrichtung 1 vorhandenen "Offset"-Gleichspannungen reduzieren sich auf diejenige Voff,v der Verstärkeranordnung 4;6;7;8. Da wegen dem Wert Null des Referenzstromes Ir ein möglicherweise vorhandener zu messender Strom $i_m$ am Ausgang des Hallelementes 5 unwirksam ist, ist in diesem ersten Messungsschritt die Spannung Vm am Ausgang m der Verstärkeranordnung 4;6;7;8 gleich der Spannung Vm,off,v, die durch die "Offset"-Gleichspannung Voff,v der Verstärkeranordnung 4;6;7;8 verursacht wird. Da die Spannung Vm,off,v konstant ist, genügt eine einzige Abtastung ihres Wertes, was mit Hilfe des zweiten Schalters 11 erfolgt, um ihren analogen Abtastwert zu erhalten, dessen Digitalwert, der gleich dem Digitalwert der Spannung Vm,off,v ist, im Computer 14 gespeichert wird.

2. In einem zweiten Messungsschritt wird mit einem von Null unterschiedlichen Wert des Referenzstromes Ir ein Wert der Spannung Ve am Ausgang e des Spannungsfolgers 3 ermittelt, der gleich dem Wert der Spannung Vb am zweiten Pol b des Stromeingangs a;b des Hallelementes 5 ist.

Zu diesem Zweck veranlasst der Computer 14 über die zugehörigen Steuereingänge 15 bis 17, dass zu Beginn des zweiten Messungsschritts die Schliesskontakte der beiden Schalter 4 und 12 geschlossen sind und derjenige des zweiten Schalters 11 geöffnet ist. Da der Referenzstrom Ir diesmal verschieden von Null ist, besitzt das Hallelement 5 in diesem zweiten Messungsschritt eine "Offset"-Gleichspannung Voff,h, die mittels der Messung der Spannung Vb und der Gleichung IV mit grosser Genauigkeit ermittelt werden kann. Da die Spannung Vb konstant ist, genügt auch hier eine einzige Abtastung ihres Wertes, was diesmal mit Hilfe des dritten Schalters 12 erfolgt, um ihren analogen Abtastwert zu erhalten, dessen Digitalwert, der gleich dem Digitalwert der Spannung Vb ist, im Computer 14 gespeichert wird.

3. Bei einem vorhandenen zu messenden Strom $i_m$ und einem vorhandenen, von Null unterschiedlichen Referenzstrom Ir werden in N weiteren Messungsschritten N Abtastwerte Vi = Vmi einer am Ausgang m der Verstärkeranordnung 4;6;7;8 anstehenden Spannung Vm ermittelt, die dem zu messenden Strom $i_m$ entspricht, wobei Vi die Eingangsspannung des Analog/Digital-Wandlers 13 darstellt. Der Index i besitzt dabei alle ganzzahligen Werte von 1 bis N.

Zu diesem Zweck veranlasst der Computer 14 über die zugehörigen Steuereingänge 15 bis 17, dass zu Beginn eines jeden dieser N weiteren Messungsschritte die Schliesskontakte der beiden Schalter 4 und 11 geschlossen sind und derjenige des dritten Schalters 12 geöffnet ist. Die Digitalwerte der N Abtastwerte Vi = Vmi werden im Computer 14 gespeichert.

4. In nachfolgenden Rechnungsschritten werden folgende Werte mittels des Computers 14 berechnet und in demselben gespeichert:

- Ein Summenwert $A = \Sigma Vmi$, mit i = 1 bis N, aller N Abtastwerte Vmi,
- ein Summenwert $B = \Sigma[Vmi]^2$, mit i = 1 bis N, der Quadratwerte aller N Abtastwerte Vmi,
- ein Wert der Spannung $Vm,off,h = G.Vb$,
- ein Wert der totalen "Offset"-Gleichspannung $Vm,off,tot = [Vm,off,h + Vm,off,v]$ und
- ein Mittelwert $Im,m = [1/F].\{[A/N] - Vm,off,tot\}$ des zu messenden Stromes.

5. In weiteren Verfahrensschritten wird der Mittelwert Im,m des zu messenden Stromes $i_m$ mit einem Referenzwert It verglichen, wobei der Referenzwert It z. B. gleich 2 Ampere ist, und der Effektivwert Ieff des zu messenden Stromes $i_m$

- falls Im,m grösser ist als der Referenzwert It, mit Hilfe einer ersten Formel $[Ieff]^2 = \{B + Vm,off,tot.[N.Vm,off,tot - 2.A]\}/[N.F^2]$ oder,
- falls Im,m kleiner ist als der Referenzwert It, mit Hilfe einer zweiten Formel $[Ieff]^2 = [B - A^2.N]/[N.F^2]$

mittels des Computers 14 berechnet und anschliessend in dem letzten gespeichert.

Die Proportionalitätskonstante F ist dabei gemäss Gleichung I die Proportionalitätskonstante, durch die die Spannung Vm am Ausgang m der Verstärkeranordnung 4;6;7;8 zu teilen ist, um den zugehörigen äquivalenten Wert des zu messenden Stromes $i_m$ zu erhalten.

Der Wert der Proportionalitätskonstante G muss, wie bereits erwähnt, für jede neue Messanordnung im voraus durch die bereits erwähnten Kalibrierungs-Verfahrensschritte ein für allemal ermittelt und im Computer 14 gespeichert werden. Die verschiedenen Messwerte des Kalibrierungsverfahrens sind nachfolgend mit einem zusätzlichen Index k gekennzeichnet.

Zur Ermittlung des Wertes der Proportionalitätskonstante G sind folgende Kalibrierungs-Verfahrensschritte erforderlich:

1. In einem ersten Messungsschritt wird mit einem Wert Null des Referenzstromes Ir, d. h. mit einem offenen Schliesskontakt des ersten Schalters 4, ein Wert der Spannung Vm,k am Ausgang m der Verstärkeranordnung 4;6;7;8 ermittelt.

Zu diesem Zweck veranlasst der Computer 14 über die zugehörigen Steuereingänge 15 bis 17, dass zu Beginn des ersten Messungsschritts die Schliesskontakte der beiden Schalter 4 und 12 geöffnet sind und derjenige des zweiten Schalters 11 geschlossen ist. Da der Referenzstrom Ir Null ist, besitzt das Hallelement 5 als passives Bauelement in diesem ersten Messungsschritt keine "Offset"-Gleichspannung Voff,h,k und die in der Messeinrichtung 1 vorhandenen "Offset"-Gleichspannungen reduzieren sich auf diejenige Voff,v,k der Verstärkeranordnung 4;6;7;8. Da wegen dem Wert Null des Referenzstromes Ir ein möglicherweise vorhandener zu messender Strom $i_{m,k}$ am Ausgang des Hallelementes 5 unwirksam ist, ist in diesem ersten Messungsschritt die Spannung Vm,k am Ausgang der Verstärkeranordnung 4;6;7;8 gleich der Spannung Vm,off,v,k, die durch die "Offset"-Gleichspannung Voff,v,k der Verstärkeranordnung 4;6;7;8 verursacht wird. Da die Spannung Vm,off,v,k konstant ist, genügt eine einzige Abtastung ihres Wertes, was mit Hilfe des zweiten Schalters 11 erfolgt, um ihren analogen Abtastwert zu erhalten, dessen Digitalwert, der gleich dem Digitalwert der Spannung Vm,off,v,k ist, im Computer 14 gespeichert wird.

2. In einem zweiten Messungsschritt wird mit einem von Null unterschiedlichen Wert des Referenzstromes Ir ein Wert der Spannung Ve,k am Ausgang des Spannungsfolgers 3 ermittelt, die gleich der Spannung Vb,k am zweiten Pol b des Stromeingangs a;b des Hallelementes 5 ist.

Zu diesem Zweck veranlasst der Computer 14 über die zugehörigen Steuereingänge 15 bis 17, dass zu Beginn des zweiten Messungsschritts die Schliesskontakte der beiden Schalter 4 und 12 geschlossen sind und derjenige des zweiten Schalters 11 geöffnet ist. Da der Referenzstrom Ir diesmal verschieden von Null ist, besitzt das Hallelement 5 in diesem zweiten Messungsschritt eine "Offset"-Gleichspannung Voff,h,k, der gemäss Gleichung IV die gemessene Spannung Vb,k entspricht, wobei die Proportionalitätskonstante G vorläufig noch unbekannt ist. Da die Spannung Vb,k konstant ist, genügt auch hier eine einzige Abtastung ihres Wertes, was diesmal mit Hilfe des dritten Schalters 12 erfolgt, um ihren analogen Abtastwert zu erhalten, dessen Digitalwert, der gleich dem Digitalwert der Spannung Vb,k ist, im Computer 14 gespeichert wird.

3. In N weiteren Messungsschritten werden mit einem zu messenden Strom $i_{m,k}$, der bei der Kalibrierung immer ein reiner Wechselstrom ohne Gleichstromkomponente ist, und einem von Null unterschiedlichen Referenzstrom Ir N Abtastwerte Vmk,i einer am Ausgang m der Verstärkeranordnung 4;6;7;8 anstehenden Spannung Vmk ermittelt. Der Index i besitzt dabei wieder alle ganzzahligen Werte von 1 bis N.

Zu diesem Zweck veranlasst der Computer 14 über die zugehörigen Steuereingänge 15 bis 17, dass zu Beginn eines jeden dieser N weiteren Messungsschritte die Schliesskontakte der beiden Schalter 4 und 11 geschlossen sind und derjenige des dritten Schalters 12 geöffnet ist. Die Digitalwerte der N Abtastwerte Vmk,i werden im Computer 14 gespeichert.

4. In zwei Rechnungsschritten werden dann noch mittels des Computers 14 nacheinander ein Summenwert Ak = ΣVmk,i, mit i = 1 bis N, aller N Abtastwerte Vmk,i und mit Hilfe der Gleichung G = {[Ak/N]-Vm,off,v,k}/Vb,k der Wert der Proportionalitätskonstante G berechnet und jeweils im Computer 14 gespeichert.

Die beiden Schalter 11 und 12 sind sowohl bei den Kalibrierungs-Verfahrensschritten als auch bei den anderen Verfahrensschritten jeweils vom Computer 14 so gesteuert, dass der Schalter 12 zwecks Messung der Spannung Vbk bzw. Vb nur jeweils im zweiten Messungsschritt und der Schalter 11 zwecks Messung der anderen Spannungen Vm,off,v,k und Vmk,i bzw. Vm,off,v und Vmi nur in allen anderen Messungsschritten geschlossen ist. Der Schalter 4 dient seinerseits dem Ein/Aus-Schalten des Referenzstromes Ir zwecks Erzeugung unter anderem von dessem Wert Null.

In dem erfindungsgemässen Verfahren wird somit jeweils der Mittelwert Im,m des zu messenden Stromes $i_m$ ermittelt und mit einem Referenzwert It verglichen. Falls der Mittelwert Im,m kleiner ist als der Referenzwert It, dann entspricht der Mittelwert Im,m einer "Offset"-Spannung und der Effektivwert Ieff des zu messenden Stromes $i_m$ ist um einen entsprechenden Wert zu korrigieren. Falls der Mittelwert Im,m grösser ist als der Referenzwert It, dann ist der Mittelwert Im,m eine Gleichstromkomponente des zu messenden Stromes $i_m$, deren entsprechender Wert im Effektivwert Ieff des zu messenden Stromes $i_m$ enthalten sein muss.

In den Figuren 2 und 3 ist die Spannung Vm = F.$i_m$ (siehe Gleichung I) in Funktion der Zeit t und sind die Abtastwerte Vi dargestellt mit den zugehörigen Werten der "Offset"-Gleichspannungen Vm,off,h und Vm,off,v sowie Vm,off,tot.

In den Darstellungen der Fig. 2 und der Fig. 3 wurde angenommen, dass der zu messende Strom $i_m$ und damit auch die Spannung Vm, die dem Strom $i_m$ proportional ist, sinusförmig sind und eine Gleichstomkomponente Im,m bzw. eine Gleichspannungskomponente F.Im,m aufweisen. Die Gleichspannungskomponente F.Im,m ist dabei jeweils gleich dem, um den Wert der totalen "Offset"-Gleichspannung Vm,off,tot = Vm,off,h + Vm,off,v (siehe Gleichung III) korrigierten Wert von A/N, der der Mittelwert der Spannung Vm bzw. der Abtastwerte Vi darstellt.

In der Fig. 2 ist Im,m grösser als der Referenzwert It und damit F.Im,m grösser als F.It.

In der Fig. 3 ist dagegen Im,m kleiner als der Referenzwert It und damit F.Im,m kleiner als F.It.

## Patentansprüche

1. Verfahren zur Ermittlung eines Effektivwertes Ieff eines mit Hilfe eines Hallelementes (5) und einer Verstärkeranordnung (4;6;7;8) zu messenden Stromes ($i_m$), der möglicherweise eine Gleichstromkomponente enthält, wobei das Hallelement (5) einem von dem zu messenden Strom ($i_m$) erzeugten Magnetfeld (Hm) ausgesetzt ist und sein Stromeingang (a;b) mit einem konstanten Referenzstrom (Ir) gespeist wird, dadurch gekennzeichnet, dass ein Mittelwert (Im,m) des zu messenden Stromes ($i_m$) ermittelt wird, dass der Mittelwert (Im,m) des zu messenden Stromes ($i_m$) mit einem Referenzwert (It) verglichen wird und dass, falls der Mittelwert (Im,m) kleiner ist als der Referenzwert (It), der Mittelwert (Im,m) einer "Offset"-Spannung entspricht und der Effektivwert (Ieff) des zu messenden Stromes ($i_m$) um einen entsprechenden Wert zu korrigieren ist, und dass, falls der Mittelwert (Im,m) grösser ist als der Referenzwert (It), der Mittelwert (Im,m) die Gleichstromkomponente des zu messenden Stromes ($i_m$) ist, deren entsprechender Wert im Effektivwert (Ieff) des zu messenden Stromes ($i_m$) enthalten sein muss.

2. Verfahren nach Anspruch 1, dadurch gekennzeichnet, dass zeitlich nacheinander
   - ein Wert einer Spannung Vm,off,v, die einer "Offset"-Gleichspannung (Voff,v) der Verstärkeranordnung (4;6;7;8) entspricht,
   - ein Wert einer Spannung Vb, die einer "Offset"-Gleichspannung (Voff,h) des Hallelementes (5) entspricht,
   - N Abtastwerte Vmi einer Spannung (Vm), die dem zu messenden Strom ($i_m$) entspricht,
   - ein Summenwert A aller N Abtastwerte Vmi,
   - ein Summenwert B der Quadratwerte aller N Abtastwerte Vmi,
   - ein Wert einer Spannung Vm,off,h = G.Vb,
   - ein Wert einer totalen "Offset"-Gleichspannung Vm,off,tot = Vm,off,h + Vm,off,v und
   - der Mittelwert Im,m = [1/F].{[A/N]-Vm,off,tot} des zu messenden Stromes ($i_m$)

   ermittelt und gespeichert werden und dass ein Effektivwert Ieff des zu messenden Stromes ($i_m$), falls der Mittelwert Im,m grösser ist als der Referenzwert (It), mit Hife einer ersten Formel [Ieff]$^2$ = {B+Vm,off,tot.[N.Vm,off,tot-2.A]}/[N.F$^2$] oder, falls der Mittelwert Im,m kleiner ist als der Referenzwert (It), mit Hilfe einer zweiten Formel [Ieff]$^2$ = [B-A$^2$/N]/[N.F$^2$] berechnet wird, wobei G und F Proportionalitätskonstanten sind und der Index i alle ganzzahligen Werte von 1 bis N besitzt.

3. Verfahren nach Anspruch 2, dadurch gekennzeichnet, dass
   - in einem ersten Messungsschritt mit einem Wert Null des Referenzstromes (Ir) an einem Ausgang (m) der Verstärkeranordnung (4;6;7;8) der Wert der Spannung Vm,off,v ermittelt und sein Digitalwert in einem Computer (14) gespeichert wird,
   - in einem zweiten Messungsschritt mit einem von Null unterschiedlichen Wert des Referenzstromes (Ir) der Wert der Spannung Vb an einem Pol (b) des Stromeingangs (a;b) des Hallelementes (5) ermittelt und sein Digitalwert im Computer (14) gespeichert wird,
   - in N weiteren Messungsschritten mit vorhandenem zu messendem Strom ($i_m$) und einem vorhandenen, von Null unterschiedlichen Wert des Referenzstromes (Ir) am Ausgang (m) der Verstärkeranordnung (4;6;7;8) die N Abtastwerte Vmi ermittelt und ihre Digitalwerte im Computer (14) gespeichert werden,

- in nachfolgenden Rechnungsschritten der Summenwert A, der Summenwert B, der Wert der Spannung Vm,off,h, der Wert der totalen "Offset"-Gleichspannung Vm,off,tot und der Mittelwert Im,m jeweils mittels des Computers (14) berechnet und in demselben gespeichert werden und

- in weiteren Verfahrensschritten der Mittelwert Im,m mit dem Referenzwert It verglichen wird und der Effektivwert Ieff mittels des Computers (14) berechnet und in dem letzten gespeichert wird,

und dass F die Proportionalitätskonstante ist, durch die die Spannung (Vm) am Ausgang (m) der Verstärkeranordnung (4;6;7;8) zu teilen ist, um den zugehörigen äquivalenten Wert des zu messenden Stromes ($i_m$) zu erhalten, sowie die proportionalitätskonstante G ein Umrechnungsfaktor ist, mit dem die durch den Referenzstrom (Ir) am Pol (b) des Stromeingangs (a;b) des Hall-elementes (5) erzeugte Spannung Vb in eine zugehörige äquivalente und am Ausgang (m) der Verstärkeranordnung (4;6;7;8) anstehende Spannung Vm,off,h umgerechnet wird.

4. Verfahren nach Anspruch 3, dadurch gekennzeichnet, dass zu Beginn in Kalibrierungs-Verfahrensschritten zuerst der Wert der Proportionalitätskonstante G ermittelt und im Computer (14) gespeichert wird.

5. Verfahren nach Anspruch 4, dadurch gekennzeichnet, dass, als Kalibrierungs-Verfahrensschritte vorhanden sind,
   - ein erster Messungsschritt, in dem mit einem Wert Null des Referenzstromes (Ir) ein Wert der Spannung Vm,off,v,k am Ausgang (m) der Verstärkeranordnung (4;6;7;8) ermittelt und sein Digitalwert im Computer (14) gespeichert wird,
   - ein zweiter Messungsschritt, in dem mit einem von Null unterschiedlichen Wert des Referenzstromes (Ir) ein Wert der Spannung Vb,k am Pol (b) des Stromeingangs (a;b) des Hallelementes (5) ermittelt und sein Digitalwert im Computer (14) gespeichert wird,
   - N weitere Messungsschritte, in denen mit einem Messstrom ($i_{m,k}$), der ein reiner Wechselstrom ohne Gleich stromkomponente ist, und mit einem von Null unterschiedlichen Referenzstrom (Ir) N Abtastwerte Vmk,i einer am Ausgang (m) der Verstärkeranordnung (4;6;7;8) anstehenden Spannung (Vmk) ermittelt und deren Digitalwerte im Computer (14) gespeichert werden, wobei der Index i alle ganzzahligen Werte von 1 bis N besitzt, und
   - zwei Rechnungsschritte, in denen mittels des Computers (14) nacheinander ein Summenwert Ak aller N Abtastwerte Vmk,i und mit Hilfe einer Gleichung $G = \{[Ak/N]-Vm,off,v,k\}/Vb,k$ der Wert der Proportionalitätskonstante G berechnet und jeweils im Computer (14) gespeichert werden.

6. Anordnung zur Durchfürung des Verfahrens nach einem der Ansprüche 1 bis 5, dadurch gekennzeichnet, dass ein Ausgang (m) der Verstärkeranordnung (4;6;7;8) über einen ersten Schalter (11) und ein Pol (b) des Stromeingangs (a;b) des Hallelementes (5) über einen zweiten Schalter (12) mit einem Eingang eines Analog/Digital-Wandlers (13) verbunden ist, dessen Ausgang auf einen Eingang des Computers (14) geführt ist, wobei die beiden Schalter (11, 12) vom Computer (14) so gesteuert sind, dass der zweite Schalter (12) zwecks Messung der Spannung (Vbk bzw. Vb) am Pol (b) des Stromeingangs (a;b) des Hall-elementes (5) nur jeweils im zweiten Messungsschritt und der erste Schalter (11) zwecks Messung der anderen Spannungen (Vm,off,v,k und Vmk,i bzw. Vm,off,v und Vmi) nur in allen anderen Messungsschritten geschlossen ist.

7. Anordnung nach Anspruch 6, dadurch gekennzeichnet, dass die Verstärkeranordnung (4;6;7;8) einen Schalter (4) enthält zum Ein/Aus-Schalten des Referenzstromes (Ir) zwecks Erzeugung von dessem Wert Null.

Fig.1

Fig.2

Fig.3

Europäisches
Patentamt

**EUROPÄISCHER
RECHERCHENBERICHT**

Nummer der Anmeldung

**EP 90 11 8646**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | GB-A-2 202 337 (UNIVERSITY OF MANCHESTER) <br> * Seite 7, Zeile 9 - Seite 9, Zeile 13; Figuren 1-4 * <br> — — — | 1-7 | G 01 <br> R 19/02 <br> G 01 R 21/08 |
| A | EP-A-0 256 183 (DUFFERS SCIENTIFIC) <br> * Zusammenfassung; Spalte 11, Zeile 24 - Spalte 12, Zeile 16; Figur 1 * <br> — — — | 1,2,6 | |
| A | RADIO FERNSEHEN ELEKTRONIK, Band 29, Nr. 1, Januar 1980, Seiten 39-42; H. KÜHNE: "Messchaltung zur Ermittlung des echter Effektivwertes" <br> * Seite 39, linke Spalte, letzter Absatz - mittlere Spalte, Absatz 1; Seite 42, linke Spalte, Absatz 1 - mittlere Spalte, Absatz 1 * <br> — — — | 1-3,5 | |
| D,A | EP-A-0 052 981 (TOKYO SHIBAURA DENKI) <br> * Zusammenfassung; Seite 4, Zeile 37 - Seite 5, Zeile 36; Seite 7, Zeile 27 - Seite 8, Zeile 23; Figuren 1,3,5 * <br> — — — — — | 1 | |
| | | | **RECHERCHIERTE SACHGEBIETE (Int. Cl.5)** <br><br> G 01 R <br> G 01 D |

Der vorliegende Recherchenbericht wurde für alle Patentansprüche erstellt

| Recherchenort | Abschlußdatum der Recherche | Prüfer |
|---|---|---|
| Den Haag | 17 April 91 | SINAPIUS G.H. |